# EUROPEAN PATENT APPLICATION

(11) **EP 3 232 208 A1**
(43) Date of publication of application: **18.10.2017**
(21) Application number: 16164996.7
(22) Date of filing: 13.04.2016
(51) Int. Cl.: G01R 23/167, G01R 29/08, G01R 31/00

(54) **A FULL TIME-DOMAIN METHOD FOR MEASURING AND MONITORING ELECTROMAGNETIC INTERFERENCE SIGNALS AND A SYSTEM**

(71) Applicant: Universitat Politècnica De Catalunya, 08034 Barcelona (ES)
(72) Inventor: SILVA MARTINEZ, Fernando, 08790 GELIDA (ES); AZPURUA AUYANET, Baron Marco Aurelio, 08028 Barcelona (ES)
(74) Representative: Juncosa Miro, Jaime

(57) **Abstract**

A full time-domain method for measuring and monitoring electromagnetic interference signals and a system

The method comprising: a) simultaneously and synchronously measuring, by an electronic test instrument (102), one or more acquired time-domain electromagnetic interference (EMI) signals; b) processing, by a computing device (103), the one or more measured time-domain EMI signals by means of: performing resolution enhancing and data reduction operations on the one or more measured time-domain EMI signals based on said Nyquist rate; filtering the one or more measured time-domain EMI signals; and applying a window function thereof; and c) performing, by the computing device (103), a non-parametric spectral estimation on said processed signal(s) by applying one or more mathematical functions on the processed signal(s) to convert them to a frequency domain, providing as a result processed signal(s) complying with specific parameters set by the EMI regulations.

## Description

### Technical Field

The present invention is directed in general to electromagnetic interference (EMI) measurements. In particular, present invention relates to a full time-domain method, and a corresponding system, for measuring and monitoring of conducted and/or radiated EMI signals. The measurement method and system comprises time-domain, frequency-domain (spectral estimation), and mixed (time-frequency) domain techniques that allow processing the direct measurement results on-line (while measuring) and/or off-line (after measuring), providing useful insights for determining compliance with Electromagnetic Compatibility (EMC) emission limits standards and also for troubleshooting EMI problems during a design stage.

### Background of the Invention

Time domain Electromagnetic Interference (TDEMI) measurements have been previously proposed as an alternative and complementary technique for assessing the electromagnetic emissions, especially those arising from transient disturbances.

Particularly, the conventional EMI testing approach is not adequate for evaluating the impact of broadband impulsive noise disturbances that affect electronic devices and digital wireless communication systems receivers as in-band interferences. This is because, the aforementioned methods were developed to protect continuous-wave analogue communication systems from interferences and, therefore, those standards and their associated measuring equipment are no longer appropriate in such situations. Likewise, even if the EMI under assessment is properly measurable using the conventional frequency domain framework, the corresponding measurement process tends to be exhaustive, costly and time-consuming.

Those problems haven't been completely addressed by the FFT-based EMI test receivers designed for standard compliant measurements according the requirements of the International Special Committee on Radio Interference (CISPR), since those equipment are focused on emulating the functioning, specifications and performance of the state-of-the-art super-heterodyne EMI receivers at the sacrifice of a comprehensive evaluation of the electromagnetic disturbance in the time-domain.

Patent application US-A1-2006043979 discloses an electromagnetic interference (EMI) measuring method and its system for diagnosing EMI of various electronic devices and instructing user to improve design to satisfy Electromagnetic Compatibility (EMC) criterion. The measuring method includes acquiring a set of time domain signal waveforms from a group of uniformly distributed test points on equipment under test (EUT), and then processing, converting, comparing and analyzing, and finally determining physical position of EMI on EUT. To implement said method, an EMI measuring system is also provided. The system includes signal acquisition portion and signal analysis portion. The signal analysis portion takes computer as carrier, which establishes processing, converting, comparing and analyzing modules on operating system platform of computer.

Patent US-B2-9239349 relates to a method of, and a system for, monitoring electromagnetic interference. The method comprising capturing a plurality of time domain waveforms, and a plurality of scatter plots; receiving the plurality of captured time domain waveforms and scatter plots; applying a Fast Fourier Transform (FFT) to each of the received time domain waveforms as it is received thereby to receive FFT outputs; storing the FFT outputs in a database; generating a statistically representative spectrograph or spectrogram in the frequency domain based on at least the stored FFT outputs and scatter plots or data associated with the scatter plots, combining constituent FFTs of the statistically representative spectrograph or spectrogram in such a manner as to emulate the result that would be produced by an EMI (Electromagnetic Interference) receiver or spectrum analyzer; and combining resultant outputs from a number of iterations of this process to produce a final result (EMI spectrum).

Patent US-B2-7613576 provides a system that monitors electromagnetic interference (EMI) signals to facilitate proactive fault monitoring in a computer system. During operation, the system receives EMI signals from one or more antennas located in close proximity to the computer system. The system then analyzes the received signals to proactively detect anomalies during operation of the computer system.

The present invention provides further improvements in this field for measuring and monitoring EMI signals in the full time-domain.

### Description of the Invention

Embodiments of the present invention provide according to a first aspect a full time-domain method for measuring and monitoring EMI signals. So, it does not require any signal processing at intermediate frequency (IF), that is, no frequency down-conversion stage is used. The method characteristically comprises:
a) measuring, by an electronic test instrument, preferably a digital real-time sampling oscilloscope, but also a digitizer or any other electronic analog-to-digital acquisition system, one or more acquired time-domain EMI signals, coming from a transducer capable to sense an EMI signal, such as antennas, line impedance stabilization networks (LISN), voltage and currents probes, etc. by taking into account certain parameters previously configured on the electronic test instrument and by sampling the one or more measured time-domain EMI signals with a sampling frequency several times higher than the Nyquist rate;
b) processing, by a computing device, either on-line or off-line, the one or more measured time-domain EMI signals by means of:
   - performing resolution enhancing and data reduction operations on the one or more measured time-domain EMI signals based on said Nyquist rate;
   - filtering the one or more measured time-domain EMI signals by removing high bandwidth components of the EMI signals and of the acquisition noise generated by the electronic test instrument;
   - equalizing the frequency response of the electronic test instrument; and
   - applying a window function of a length and shape factor such as it provides a maximal energy concentration in the window main lobe which is optimal for meeting the standard selectivity requirements for EMI testing while assuring low spectral leakage for meeting high dynamic range measurements; and
c) performing, by the computing device, a non-parametric spectral estimation on said processed signal(s) by applying one or more mathematical functions on the processed signal(s) to convert them to a frequency domain, providing as a result processed signal(s) complying with the specific parameters set by the EMI regulations specified for domestic, commercial, industrial, medical, scientific, automotive and/or military and aerospace environments and products.

According to the proposed method, said certain parameters include the frequency resolution of the time-domain EMI signal(s) to be measured, bandwidth and sensibility thereof, and the time acquisition of the electronic test instrument.

In addition, the one or more time-domain EMI signals are simultaneously and synchronously measured.

The processed signal(s) obtained in step b) can be used for performing further EMI analysis in the time-domain including: an instantaneous frequency analysis and Hilbert spectrum, EMI signal decomposition, a calculation of common mode and/or differential mode noise.

The one or more acquired time-domain EMI signals can be pre-amplified before being measured by the electronic test instrument.

According to an embodiment, said resolution enhancing and data reduction operations are performed by means of a Gaussian process regression used to uniformly resample the one or more measured time-domain EMI signals through a best linear unbiased prediction (e.g. Wiener-Kolmogorov) of the intermediate values (e.g. an interpolation) of the one or more measured time-domain EMI signals.

According to an embodiment, said filtering of the one or more measured time-domain EMI signals is performed by a Finite Impulse Response filter. Filter cutoff frequency, frequency response, and flatness are defined taking into consideration an analog bandwidth of the electronic test instrument and the bandwidth of the one or more measured time-domain EMI signals.

According to the proposed method, the one or more mathematical functions may comprise a Welch's method, a Short-Time Fourier Transform, or a standard weighting detector emulation by applying a correction factor calculated using a Welch's method and a Short-Time Fourier Transform.

Other embodiments of the present invention that are disclosed herein also include, according to a second aspect, a system for implementing the method of the first aspect.

According to an embodiment, the computing device (e.g. a personal computer (PC), a notebook, etc.) and the electronic test instrument (preferably a digital real-time sampling oscilloscope, but also a digitizer or any other electronic analog-to-digital acquisition system) are remote to each other. The electronic test instrument and the computing device may be connected either via a wireless connection or via a wired connection. Alternatively, according to another embodiment, the computing device forms part of the electronic test instrument (e.g. a computing unit of an oscilloscope).

The proposed system may further comprise pre-amplifier(s) operatively connected to the electronic test instrument and arranged and adapted to pre-amplify the acquired one or more time-domain EMI signals before being measured by the electronic test instrument.

Therefore, present invention simplifies the measurement setups to evaluate the emissions at several different ports of the electronic test instrument simultaneously, i.e., disturbance signals measured at several the lines of the mains network simultaneously or using multiple antennas with different polarization and frequency bands to reduce the iteration required for covering the measurement of the emissions of certain Equipment Under Test (EUT) during EMI assessments.

### Brief Description of the Drawings

The previous and other advantages and features will be more fully understood from the following detailed description of embodiments, with reference to the attached figures, which must be considered in an illustrative and non-limiting manner, in which:
Fig. 1 is a schematic block diagram of a full time-domain EMI measurement system according to an embodiment of the present invention.
Fig. 2 is a flow chart of a method for measuring and monitoring electromagnetic interference (EMI) signals in the full time-domain according to an embodiment of the present invention.
Figs. 3 to 5 are three different application examples of the present invention.

### Detailed Description of Preferred Embodiments

Present invention provides a system and a method for measuring and monitoring Electromagnetic Interferences (EMI) signals using a multichannel/multiport, full-spectrum, simultaneous and synchronous, adaptive resolution and entirely time-domain based approach for reliable assessment of conducted and/or radiated electromagnetic interferences.

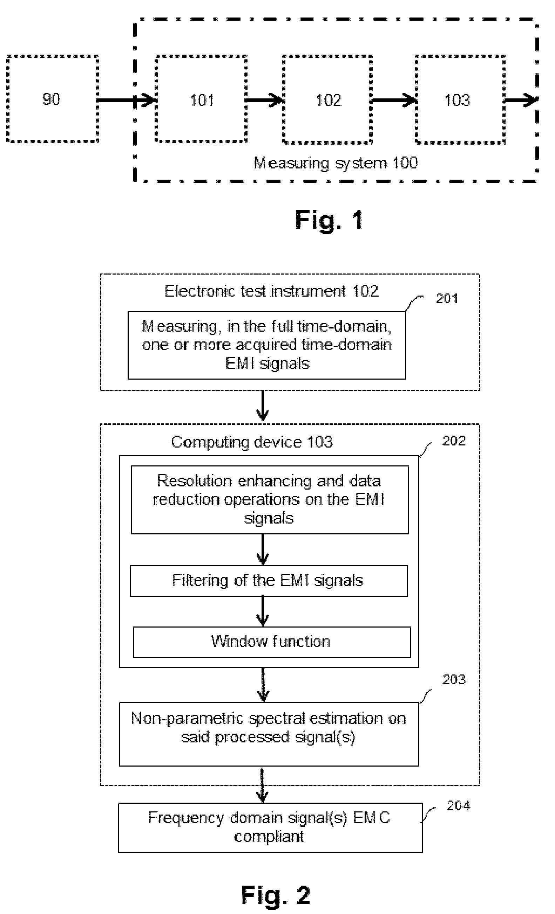

Fig. 1 shows an embodiment of the proposed system. For the acquisition of radiated and conducted EMI signals an appropriate EMI transducer 90 shall be used such as antennas, line impedance stabilization networks (LISN), voltage and currents probes, etc. The EMI signals could be periodic or sporadic, continuous wave or transient, narrowband or broadband, stationary, quasi-stationary or random EMI signals.

The proposed system 100, according to this embodiment, includes a pre-amplifier 101 operatively connected to an electronic test instrument 102 to pre-amplify the acquired one or more time-domain EMI signals before being measured by the electronic test instrument 102. The electronic test instrument, which may be a digital real-time sampling oscilloscope, a digitizer or any other electronic analog-to-digital acquisition system, is responsible of simultaneously and synchronously measure the pre-amplified signals. Finally, the system also includes a computing device 103 to process the measured pre-amplified EMI signals and to perform a non-parametric spectral estimation on it to convert them to the frequency domain.

According to the invention, the computing device 103 can be a personal computer (PC), or a Tablet, among many other computing devices with processing capabilities, remote to the electronic test instrument 102 and connected thereto either via a wireless connection or via a wired connection. Alternatively, the computing device 103 can be a computing unit/module of the electronic test instrument 102.

Even the above-described embodiment uses a pre-amplifier the use of such unit is not mandatory as in other embodiments, in this case not illustrated, the acquired EMI signals are directly measured by the electronic test instrument 102 without being previously pre-amplified.

With reference now to Fig. 2, therein it is illustrated an embodiment of the proposed method. According to this embodiment, the electronic test instrument 102, at step 201, simultaneously and synchronously measures one or more acquired time-domain EMI signals by means of taking into account certain parameters previously adapted on the electronic test instrument 102 (e.g. frequency resolution of the signal(s) to be measured, bandwidth and sensibility thereof, and the time acquisition of the electronic test instrument 102) and by sampling in real-time the one or more measured time-domain EMI signals with a sampling frequency several times higher than the Nyquist rate. Then, at step 202, the computing device 103 processes, either on-line (while measuring) and/or off-line (after measuring), the one or more time-domain EMI signals by means of performing resolution enhancing and data reduction operations on them based on said Nyquist rate and by filtering and applying a window function on the one or more measured time-domain EMI signals. Once the signals have been processed, the computing device 103, step 203, performs a non-parametric spectral estimation on the processed signals by applying one or more mathematical functions (e.g. Welch's method, a Short-Time Fourier Transform, or a standard weighting detector emulation by applying a correction factor calculated using a Welch's method and a Short-Time Fourier Transform, among others) implementing an algorithm that converts them into a frequency domain. So, finally, step 204, the resulting signals comply with specific parameters set by the EMI regulations, specified for domestic, commercial, industrial, medical, scientific, automotive and/or military and aerospace environments and products.

The resolution enhancing and data reduction operations on the raw time-domain EMI data (the signal or signals) is preferably performed by means of a Gaussian process regression used to uniformly resample the raw time-domain EMI data through the best linear unbiased prediction (e.g. Wiener-Kolmogorov) of the intermediate values (interpolation) that correspond to the EMI sampled at the exact Nyquist rate.

In the example embodiment, the filtering is performed by a Finite Impulse Response filter that avoids aliasing, and removes high bandwidth components of the EMI signals and high bandwidth components of the acquisition noise generated by the electronic test instrument 102 and equalizes the frequency response of the electronic test instrument 102. The filter cutoff frequency, frequency response, and flatness are defined taking into consideration the analog bandwidth of the electronic test instrument 102 and the measurement bandwidth required for the EMI assessment. According to the invention other bandpass filters can be also used to attenuate without departing from the scope of protection of the invention.

Besides, in the example embodiment, the applied window function is a digital prolate spheroidal sequence (DPSS) window of a length and shape factor such as it provides a maximal energy concentration in the window main lobe which is optimal for meeting a standard selectivity requirement for EMI test receivers selectivity while assuring low spectral leakage for meeting high dynamic range measurements. According to the invention other window functions can be also used without departing from the scope of protection of the invention.

The proposed entirely time-domain approach allows performing further EMI analysis such as: instantaneous frequency analysis and Hilbert spectrum, EMI signal decomposition, calculation of Common Mode and/or Differential Mode noise, statistical analysis of the EMI in the time-domain, etc.

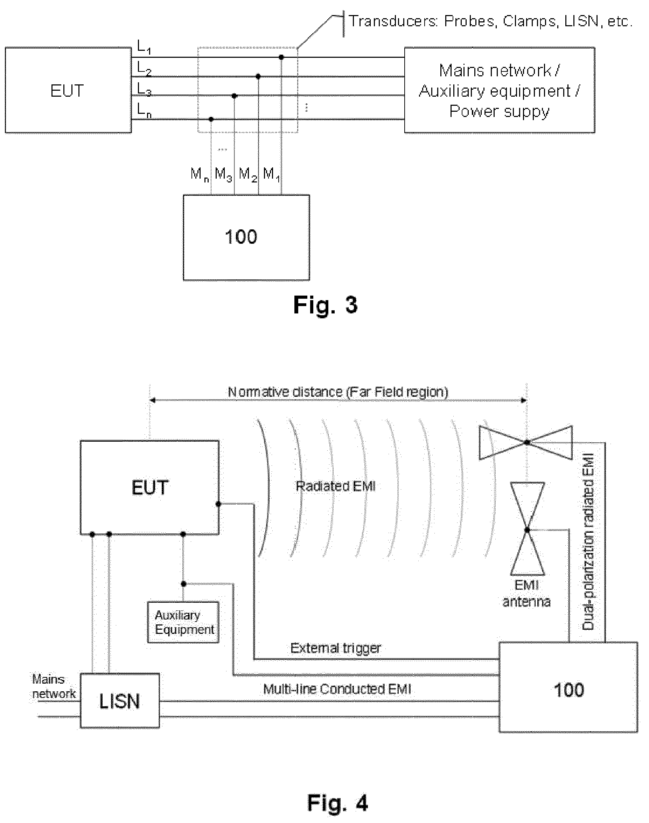

With reference to Figs. 3 to 5, these figures illustrate three different application examples of the present invention.

Fig. 3 illustrates an application example for performing simultaneous and synchronous multiline EMI measurement. Derived measurement results such as the differential mode and common mode noise can be calculated from the EMI measurands Mᵢ (i.e. voltage, current) at the different Equipment Under Test (EUT) lines Lᵢ (i.e. power, signal or control) because they have been measured simultaneous and synchronously by the proposed system 100.

Fig. 4 illustrates another application example for a single stage conducted and radiated EMI measurements. It measures simultaneously the conducted and the radiated EMI, saving testing time and providing a method that correlates both radiated and conducted emissions. This is extremely valuable when troubleshooting non-compliance, i.e., unsteady broadband disturbances with both conducted and radiated impact.

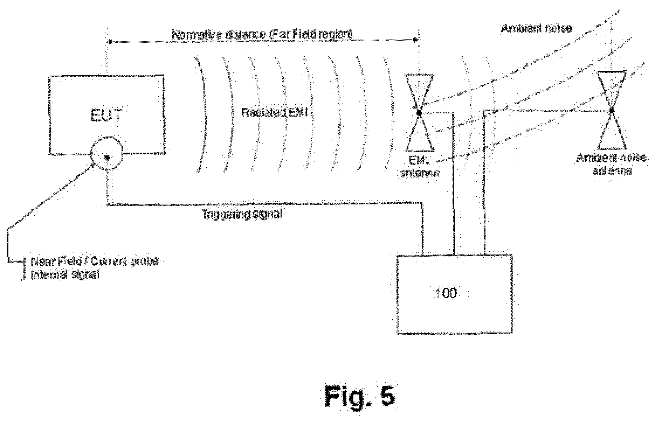

Fig. 5 illustrates another application example for advanced time-domain ambient noise identification, reduction or cancellation for radiated EMI measurements. In this case, it is possible to process measurement results in order to estimate the radiated EMI even when the measurements are carried out in the presence of ambient noise. This is achieved by processing the simultaneous and synchronous measurements of the radiated EMI in the presence of ambient noise (antenna placed at the normative distance), the isolated ambient noise captured by an antenna placed far away from the EUT (so the radiated EMI is sufficiently attenuated) and a triggering signal taken from the EUT.

The scope of the present invention is defined in the following set of claims.

## Claims

1. A full time-domain method for measuring and monitoring electromagnetic interference signals, the method comprising:
a) measuring, by an electronic test instrument (102), one or more acquired time-domain electromagnetic interference, EMI, signals, by taking into account certain parameters previously configured on the electronic test instrument (102) and by sampling the one or more measured time-domain EMI signals with a sampling frequency several times higher than the Nyquist rate,
wherein said certain parameters including the frequency resolution of the time-domain EMI signal(s) to be measured, bandwidth and sensibility thereof, and the time acquisition of the electronic test instrument (102), and
wherein the one or more time-domain EMI signals being simultaneously and synchronously measured,
b) processing, by a computing device (103), the one or more measured time-domain EMI signals by means of:
- performing resolution enhancing and data reduction operations on the one or more measured time-domain EMI signals based on said Nyquist rate;
- filtering the one or more measured time-domain EMI signals by removing high bandwidth components of the EMI signals and high bandwidth components of acquisition noise generated by the electronic test instrument (102);
- equalizing the frequency response of the electronic test instrument (102); and
- applying a window function of a length and shape factor such as it provides a maximal energy concentration in a window main lobe which is optimal for meeting standard selectivity requirements for EMI testing while assuring low spectral leakage for meeting high dynamic range measurements; and
c) performing, by the computing device (103), a non-parametric spectral estimation on said processed signal(s) by applying one or more mathematical functions on the processed signal(s) to convert them to a frequency domain, providing as a result processed signal(s) complying with specific parameters of the EMI regulations.

2. The method of claim 1, comprising performing said resolution enhancing and data reduction operations by means of a Gaussian process regression used to uniformly resample the one or more measured time-domain EMI signals through a best linear unbiased prediction of the intermediate values of the one or more measured time-domain EMI signals.

3. The method of claim 1, comprising performing said filtering of the one or more measured time-domain EMI signals by a Finite Impulse Response filter, wherein a filter cutoff frequency, frequency response, and flatness are defined taking into consideration an analog bandwidth of the electronic test instrument (102) and the bandwidth of the one or more measured time-domain EMI signals.

4. The method of claim 1, wherein said one or more mathematical functions comprising a Welch's method, a Short-Time Fourier Transform, or a standard weighting detector emulation by applying a correction factor calculated using a Welch's method and a Short-Time Fourier Transform.

5. The method of claim 1, wherein said window function comprising a digital prolate spheroidal sequence (DPSS) window.

6. The method of any of previous claims, comprising using the processed signal(s) obtained in step b) for performing further EMI analysis in the time-domain including: an instantaneous frequency analysis and Hilbert spectrum, EMI signal decomposition, a calculation of common mode and/or differential mode noise.

7. The method of claim 1, wherein the one or more acquired time-domain EMI signals being pre-amplified before being measured by the electronic test instrument (102).

8. The method of claim 1, comprising performing said processing of the one or more measured time-domain EMI signals on-line or off-line.

9. The method of any of previous claims, wherein the electronic test instrument (102) is a digital real-time sampling oscilloscope, a digitizer or any other electronic analog-to-digital acquisition system.

10. A system for measuring and monitoring electromagnetic interferences signals in the full time-domain, the system comprising:
- an electronic test instrument (102) arranged and adapted to measure one or more acquired time-domain electromagnetic interference, EMI, signals, by taking into account certain parameters previously adapted on the electronic test instrument (102), and by sampling the one or more measured time-domain EMI signals with a sampling frequency several times higher than the Nyquist rate,
wherein said certain parameters including the frequency resolution of the signal(s) to be measured, bandwidth and sensibility thereof, and the time acquisition of the electronic test instrument (102); and
wherein the electronic test instrument (102) being arranged and adapted to simultaneously and synchronously measure the one or more time-domain EMI signals,
- a computing device (103) operatively connected to the electronic test instrument (102) adapted to:
- process the one or more measured time-domain EMI signals by means of: perform resolution enhancing and data reduction operations on the one or more measured time-domain EMI signals based on said Nyquist rate; filtering the one or more measured time-domain EMI signals by removing high bandwidth components of the EMI signals and high bandwidth components of acquisition noise generated by the electronic test instrument (102); and equalizing the frequency response of the electronic test instrument (102); and applying a window function of a length and shape factor such as it provides a maximal energy concentration in a window main lobe which is optimal for meeting standard selectivity requirements for EMI testing while assuring low spectral leakage for meeting high dynamic range measurements; and
- perform a non-parametric spectral estimation on said processed signal(s) by applying one or more mathematical functions on the processed signal(s) to convert them to a frequency domain, so that the processed signal(s) comply with the parameters of the EMI regulations.

11. The system of claim 10, wherein the computing device (103) is remote to the electronic test instrument (102).

12. The system of claim 10, wherein the computing device (103) is a computing unit of the electronic test instrument (102).

13. The system of claim 10, further comprising a pre-amplifier (101) operatively connected to the electronic test instrument (102) and arranged and adapted to pre-amplify the acquired one or more time-domain EMI signals before being measured by the electronic test instrument (102).

14. The system of any of previous claims 10 to 13, wherein the electronic test instrument (102) is an oscilloscope including a digital real-time sampling oscilloscope, a digitizer or any other electronic analog-to-digital acquisition system.
